# EUROPEAN PATENT APPLICATION

(11) **EP 4 478 123 A1**
(43) Date of publication of application: **18.12.2024**
(21) Application number: 24175817.6
(22) Date of filing: 14.05.2024
(51) Int. Cl.: G02F 1/1345, G02F 1/1362

(54) **CIRCUIT SUBSTRATE AND ELECTRONIC DEVICE**

(30) Priority: 08.06.2023 CN 202310677451
(71) Applicant: InnoLux Corporation, Chu-Nan, Miao-Li 350 (TW)
(72) Inventor: PAN, Mei-Hsiu, 350 Miao-Li County (TW); YEN, Chung-Wen, 350 Miao-Li County (TW); CHEN, Shing-Fei, 350 Miao-Li County (TW)
(74) Representative: 2K Patentanwälte Blasberg Kewitz & Reichel

(57) **Abstract**

A circuit substrate with multiple voltage input ports. A substrate has an active area and a peripheral area surrounding the active area. A signal transmitting structure is disposed on the active area and the peripheral area. A conductive structure is disposed on the peripheral area, and is electrically connected to the signal transmitting structure. The conductive structure includes first conductive wiring, second conductive wiring, and converging wiring. At the first end of the converging wiring, the converging wiring receives a first signal from the first conductive wiring, and receives a second signal from the second conductive wiring. The converging wiring outputs a third signal to the signal transmitting structure through its second end. The third signal is a common voltage.

## Description

### CROSS REFERENCE TO RELATED APPLICATIONS

This Application claims priority of China Patent Application No. 202310677451.8, filed on June 08, 2023, the entirety of which is incorporated by reference herein.

### BACKGROUND OF THE DISCLOSURE

### Field of the Disclosure

The present disclosure relates to a circuit substrate.

### Description of the Related Art

In an image display, each pixel is driven by a voltage difference between a data signal and a common voltage (Vcom). The common voltage (Vcom) is ideally a constant DC voltage.

In actual operation, other signals can easily interfere with the common voltage (Vcom). RC loading also causes the common voltage (Vcom) to shift.

How to provide a stable common voltage (Vcom) to make the display stable is an important issue in this technical field.

### BRIEF SUMMARY OF THE DISCLOSURE

A circuit substrate in accordance with an exemplary embodiment of the present disclosure has multiple voltage input ports. The circuit substrate has a substrate, a signal transmitting structure, and a conductive structure. The substrate includes an active area and a peripheral area surrounding the active area. The signal transmitting structure is disposed on the active area and the peripheral area. The conductive structure is disposed on the peripheral area, and is electrically connected to the signal transmitting structure. The conductive structure has first conductive wiring, second conductive wiring, and converging wiring. The converging wiring is electrically connected to the first conductive wiring and the second conductive wiring, and has a first end and a second end. A first signal from the first conductive wiring and a second signal from the second conductive wiring are transferred to the converging wiring through the first end of the converging wiring. The converging wiring outputs a third signal to the signal transmitting structure through the second end. The third signal may be a common voltage (Vcom).

In an exemplary embodiment, the first conductive wiring and the second conductive wiring are disposed in a mirrored way relative to the converging wiring. In this manner, the common voltage Vcom is more stable, and an image is ideally displayed.

In an exemplary embodiment, the circuit substrate is used in an electronic device. In additional to the circuit substrate, the electronic device further has a first circuit board, and a second circuit board. The first circuit board is bonded to the circuit substrate, and operative to provide the first conductive wiring with the first signal. The second circuit board is connected with the circuit substrate, and operative to provide the second conductive wiring with the second signal. The electronic device may further comprise a color filter, and a liquid-crystal layer. The liquid-crystal layer may be disposed between the circuit substrate and the color filter. The electronic device may be a display device.

A detailed description is given in the following embodiments with reference to the accompanying drawings.

### BRIEF DESCRIPTION OF THE DRAWINGS

The present disclosure can be more fully understood by reading the subsequent detailed description and examples with references made to the accompanying drawings, wherein:
FIG. 1A illustrates a circuit substrate 100 in accordance with an exemplary embodiment of the present disclosure;
FIG. 1B further shows a transparent conductive layer 110 of the signal transmitting structure;
FIG. 2A and FIG. 2B illustrate various patterns of the conductive structure (including the first conductive wiring D1, the second conductive wiring D2, and the converging wiring D);
FIG. 3 illustrates an electrostatic protection component for electrostatic discharge (ESD) design in accordance with an exemplary embodiment of the present disclosure;
FIG. 4A and FIG. 4B each illustrates a bridge structure B in accordance with the different exemplary embodiments of the present disclosure;
FIG. 5 illustrates a pad connection design for the first conductive wiring D1 (or the second conductive wiring D2) in accordance with an exemplary embodiment of the present application; and
FIG. 6 illustrates a cross-sectional view of a display device in accordance with an exemplary embodiment of the present application.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

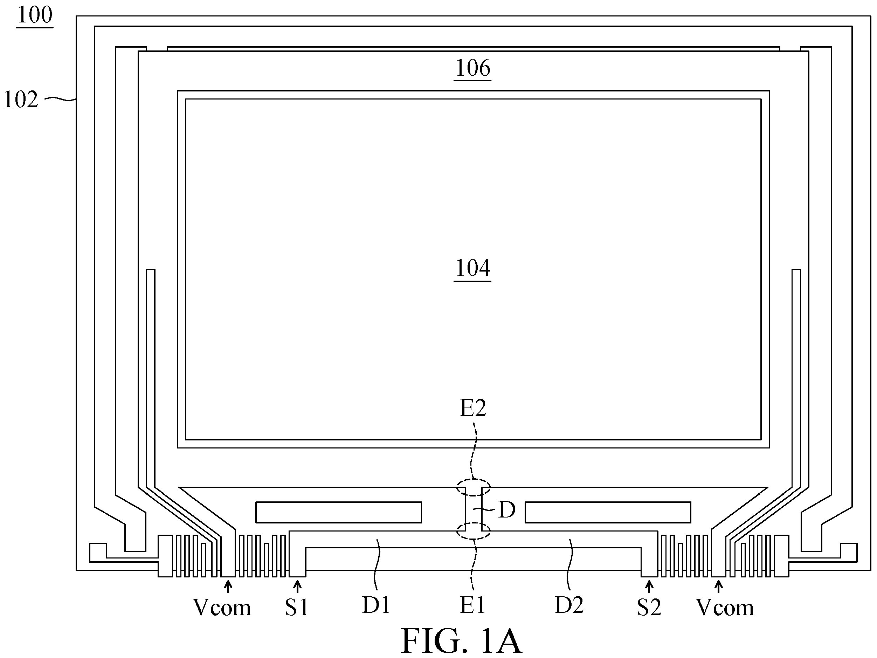

FIG. 1A illustrates a circuit substrate 100 in accordance with an exemplary embodiment of the present disclosure, wherein a substrate 102 includes an active area 104, and a peripheral area surrounding the active area 104. A signal transmitting structure is disposed on the active area 104 and the peripheral area. The signal transmitting structure includes a conductive ring 106 disposed on the peripheral area.

In particular, the circuit substrate 100 further has a conductive structure disposed on the peripheral area and electrically connected to the signal transmitting structure (106). The conductive structure has first conductive wiring D1, second conductive wiring D2, and converging wiring D. The converging wiring D is electrically connected to the first conductive wiring D1 and the second conductive wiring D2, and the converging wiring D has a first end E1 and a second end E2. Through the first end E1, the converging wiring D receives a first signal S 1 from the first wiring D 1, and receives a second signal S2 from the second wiring D2. The converging wiring D outputs a third signal (called S3) at its second end E2 to be transmitted to the signal transmitting structure (106). In an exemplary embodiment of the present disclosure, the first signal S 1, the second signal S2, and the third signal S3 all are the common voltage Vcom, but not limited thereto.

As shown in the figure, the conductive ring 106 itself has input ports to receive the common voltage Vcom, which can be regarded as the main input of the common voltage Vcom. In the present disclosure, auxiliary input ports for receiving the common voltage Vcom are proposed. The first conductive wiring D1 and the second conductive wiring D2 are in a mirrored layout relative to each other. Through the flexible printed circuit (FPC) boards at the left half and the right half of the long side of the circuit substrate 100, the auxiliary input of the common voltage Vcom is entered and then conveyed to the converging wiring D to be coupled to the conductive ring 106. In an exemplary embodiment, the common voltage Vcom received by the auxiliary input ports is coupled to the conductive ring 106 to the center point of the conductive ring 106 at the long side of the circuit substrate 100.

The common voltage Vcom that is converged to the converging wiring D through the mirrored paths D1 and D2 will balance the interference of resistors and capacitors, and reduce the display difference between the left half image and right half image. In particular, if any of the first conductive wiring D1 and the second conductive wiring D2 is broken, the converging wiring D still uniformly conveys the common voltage Vcom to the long side of the conductive ring 106.

The conductive ring 106 in the figure fully surrounds the active area 104. In the other exemplary embodiments, the conductive ring 106 has an opening. The conductive ring 106 is adjacent to at least three sides of the active area 104.

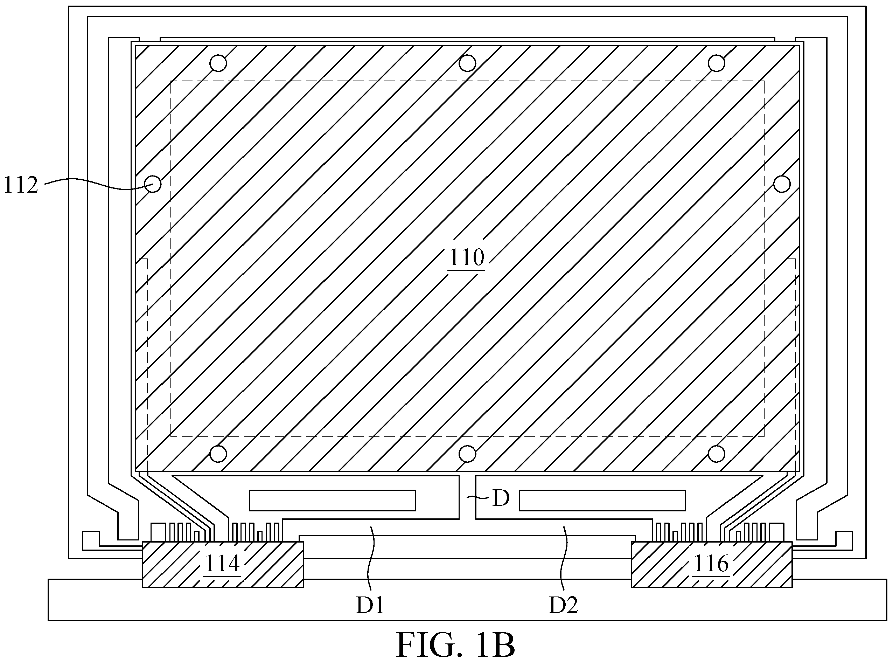

FIG. 1B further shows a transparent conductive layer 110 of the signal transmitting structure, which is disposed over the active area 104 and a part of the peripheral area. The transparent conductive layer 110 is electrically connected (via the via holes 112) to the conductive ring 106.

The circuit substrate 100 is further used to implement an electronic device, such as a liquid-crystal display, a light-emitting display, and various other kinds of display devices, or even non-display devices. Referring to FIG. 1B, the electronic device further includes a first circuit board 114 and a second circuit board 116. The first circuit board 114 is bonded to the circuit substrate 100 to provide the first conductive wiring D1 with the first signal (S1=Vcom). The second circuit board 116 is also bonded to the circuit substrate 100 to provide the second conductive wiring D2 with the second signal (S2=Vcom). The electronic device may include a display device, a backlight device, an antenna device, a sensing device, or an assembled device, but not limited thereto. The electronic device may be a bendable or flexible electronic device. The display device may be a non-self-illuminating display device or a self-illuminating display device. The antenna device may be a liquid-crystal type antenna device or a non-liquid-crystal type antenna device. The sensing device may sense capacitance, light, thermal energy or ultrasonic waves, but not limited thereto. The electronic device may include passive components or active components, such as capacitors, resistors, inductors, diodes, transistors, and the like. The diodes may be light-emitting diodes or photodiodes. The light-emitting diodes may include, for example, an organic light-emitting diode (OLED), a mini LED, a micro LED, or a quantum dot LED, but not limited thereto. The assembled device may be, for example, an assembled display device or an assembled antenna device, but not limited thereto. It should be noted that, the electronic device can be any combination of the components/devices mentioned above, but not limited thereto. In the following, the display device is used as an electronic device or an assembled device to illustrate the present disclosure, but the present disclosure is not limited thereto.

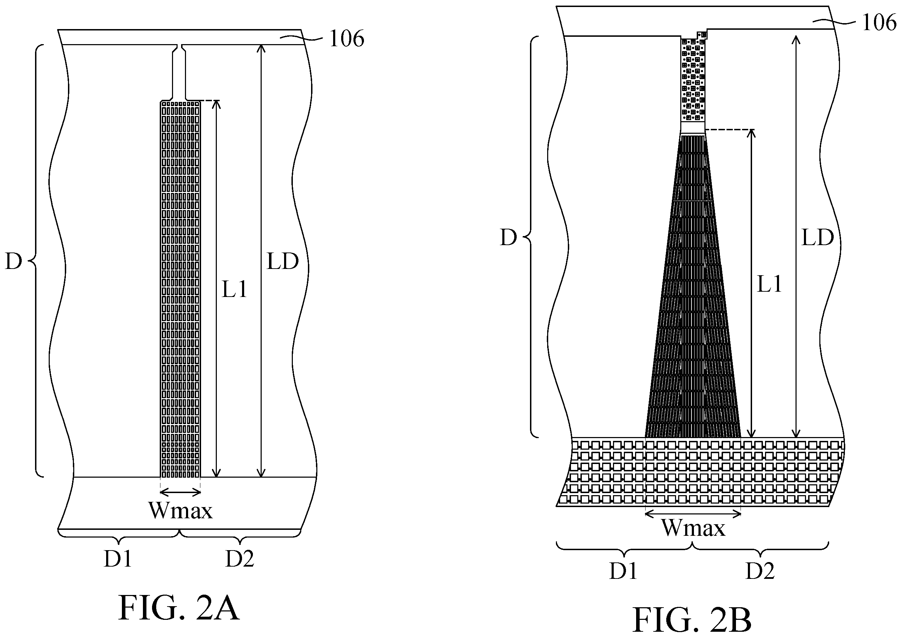

FIG. 2A and FIG. 2B illustrate various patterns of the conductive structure (including the first conductive wiring D1, the second conductive wiring D2, and the converging wiring D). As shown, the first conductive wiring D1 and the second conductive wiring D2 in the drawings are parallel and mirrored wirings converged to the converging wiring D, and the tower shape of the converging wiring D has various designs. In some other exemplary embodiments, the first conductive wiring D1 and the second conductive wiring D2 conform to the layout of the surrounding circuits, and converge to the converging wiring D in a slope-shaped and mirrored way. In addition to the illustrated contents, the pattern details may include the grid wiring or fence wiring. The figures show that the first conductive wiring D1 and the second conductive wiring D2 are disposed in a mirrored way.

The width of the converging wiring D is also specially designed. The measurement direction of the so-called width is perpendicular to the extension direction of the converging wiring D. As limited by the layout of the other circuits, the converging wiring D may not be of equal width. According to the maximum width Wmax of the converging wiring D, the converging wiring D may be divided to include a first portion (the wider portion) and a second portion (the narrower portion). The portion reaching the maximum width Wmax of the converging wiring D by a specific percentage is regarded as the first portion (the wider portion), and the rest of the area is regarded as the second portion (the narrower portion). In addition, the length (along the extension direction of the converging wiring D) is also specially designed. The overall length of the converging wiring D is LD, and the length of its first portion (the wider portion) is L1. The length L1 of the first portion (the wider portion) needs to account for more than a certain percentage of the overall length LD of the converging wiring D.

In FIG. 2B, the converging wiring D with unequal width is shown. In FIG. 2A, the converging wiring D with equal width is shown. These converging wirings D do follow the aforementioned proportional principles. With such a design, the converging wiring D can be controlled at a reasonable resistance value, which reduces the degree of voltage drop due to the signal transmission, and guarantees the potential of the in-plane common voltage Vcom.

In an exemplary embodiment, the portion whose width is not narrower than 30% of the maximum width Wmax (>30%Wmax) is the first portion (the wider portion), and the remainder is the second portion (the narrower portion).

In an exemplary embodiment, the ratio of the length L1 of the first portion (the wider portion) to the overall length LD is greater than (or equal to) 50%.

In another exemplary embodiment, the ratio of the length L1 of the first portion (the wider portion) to the overall length LD is greater than (or equal to) 70%.

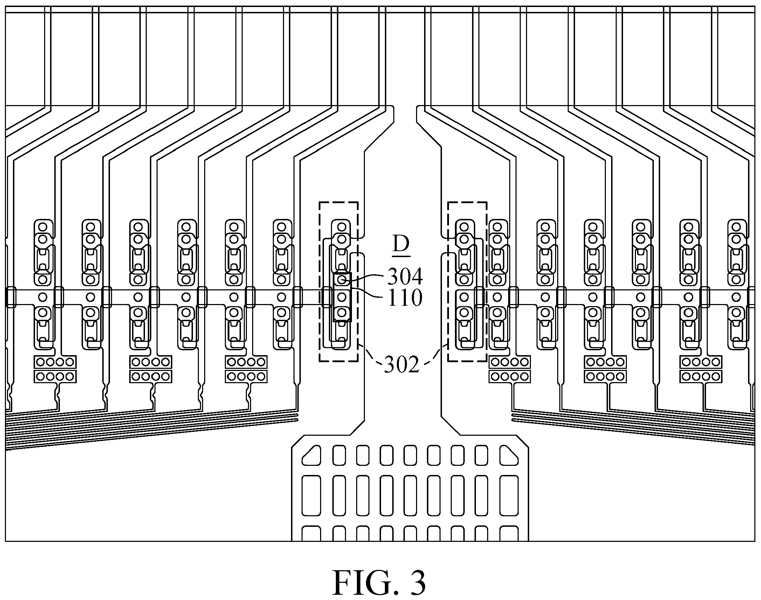

FIG. 3 illustrates an electrostatic protection component for electrostatic discharge (ESD) design in accordance with an exemplary embodiment of the present disclosure. As shown in the figure, the circuit substrate 100 further includes electrostatic protection components 302 electrically connected to the converging wiring D. The transparent conductive layer 110 may be electrically connected with the electrostatic protection components 302 through the via holes 304. Due to resistance considerations, the converging wiring D is wider than the data lines. In order to protect the in-plane components from being damaged through the electrostatic path, the electrostatic protection components 302 for the converging wiring D are disposed on the periphery around the conductive ring 106.

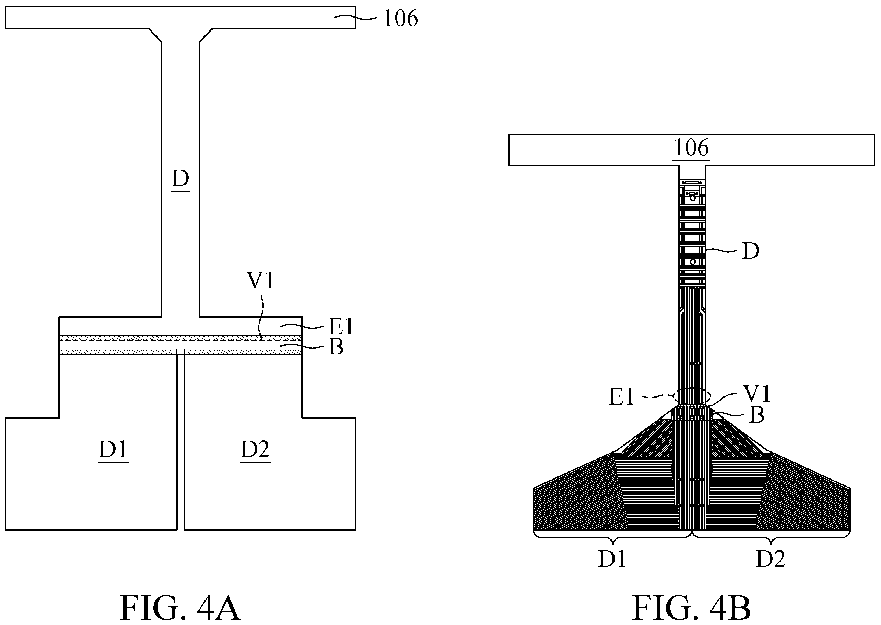

FIG. 4A and FIG. 4B each illustrates a bridge structure B in accordance with the different exemplary embodiments of the present disclosure. In addition to the above-mentioned first conductive wiring D1, second conductive wiring D2, and converging wiring D, the conductive structure provided for the auxiliary input of the common voltage Vcom further includes a bridge structure B. The first conductive wiring D1 is electrically connected to the first end E1 of the converging wiring D through the bridge structure B. The second conductive wiring D2 is also electrically connected to the first end E1 of the converging wiring D through the bridge structure B. As shown in the figure, the bridge structure B has rows of equidistant via holes V1 for conducting the bridge structure B with the first conductive wiring D1, conducting the bridge structure B with the second conductive wiring D2, and conducting the bridge structure B with the converging wiring D. The electrical connection between the different layers is realized by the bridge structure B.

In an exemplary embodiment, the bridge structure B is built in a first layer of the circuit substrate 100, and the first conductive wiring D1, the second conductive wiring D2, and the converging wiring D are built in a second layer of the circuit substrate 100. The first layer and the second layer have different distances from the substrate 102. For example, the distance of the first layer from the substrate 102 is greater than the distance of the second layer from the substrate 102. Such conductive bridge design between the different layers may improve the resistance control of the entire conductive path. The voltage difference between the Vcom auxiliary input (entered through D1 and D2 ) and the Vcom main input (directly supplied to the conductive ring 106) can be reduced. The conductive bridge design (B) between the different layers also has an electrostatic protection function.

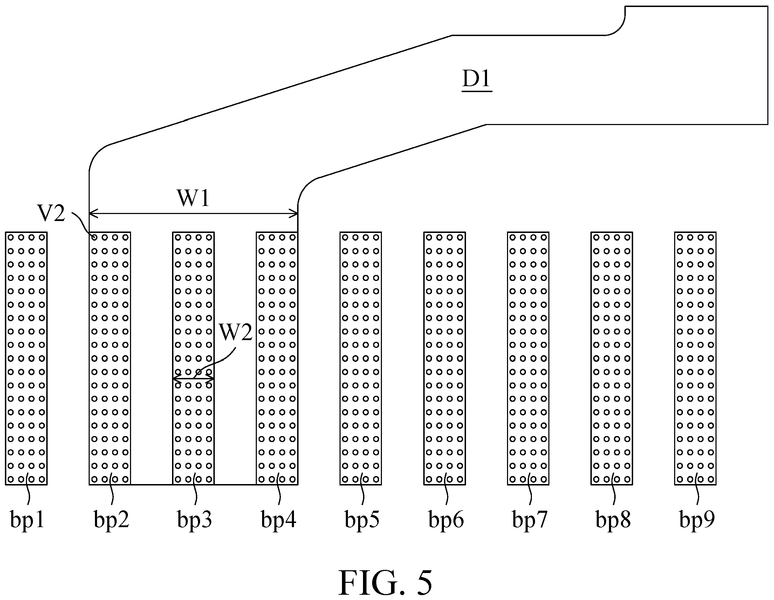

FIG. 5 illustrates a pad connection design for the first conductive wiring D1 in accordance with an exemplary embodiment of the present application, and this technology is also applied to the second conductive wiring D2.

The circuit substrate 100 includes a plurality of bonding pads bp1^{~}bp9 disposed on the peripheral area. It is shown that the first conductive wiring D1 is electrically connected to three pads bp2, and bp3, bp4 through a plurality of via holes V2 . The width W1 of the first conductive wiring D1 is more than twice the width W2 of each pad bp2/bp3/bp4. In some exemplary embodiments, the first conductive wiring D1 is electrically connected to at least two of the pads. Such cross-pad connection design can effectively reduce the interface resistance and protect the Vcom auxiliary input from being affected by the surrounding signals.

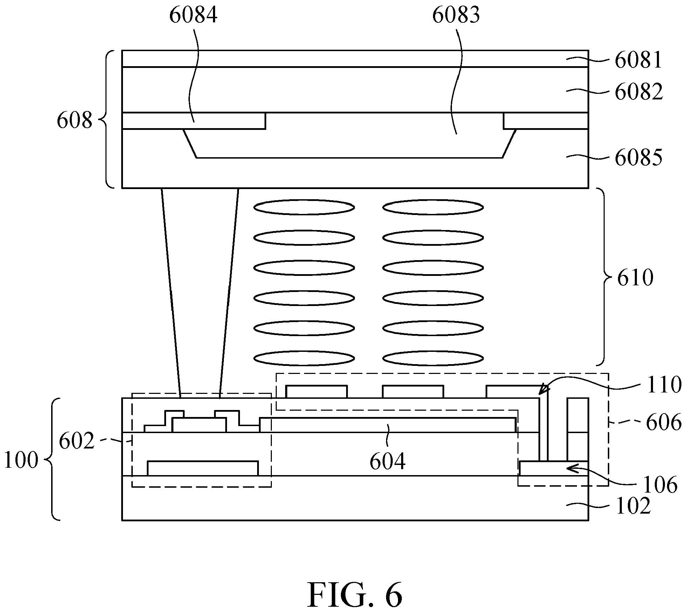

FIG. 6 illustrates a cross-sectional view of a display device in accordance with an exemplary embodiment of the present application, wherein an active component 602 is disposed on the active area 104 of the substrate 102. The pixel electrode 604 is electrically connected to the active component 602. The pixel electrode 604 and the conductive structure 606 (such as the transparent conductive layer 110) overlap each other. The display device further includes a color filter 608 (for example, including a back-plated transparent conductive layer 6081, a substrate 6082, a layer of dye 6083, a black matrix 6084, a protection layer 6085 and so on), and a liquid-crystal layer 610. The liquid-crystal layer 610 is disposed between the circuit substrate 100 and the color filter 608.

In an exemplary embodiment, a liquid-crystal display (LCD) with the aforementioned technology is shown, wherein the LCD uses TFTs. In addition to the liquid-crystal panel technology, the auxiliary Vcom input design may be also applied to any other display technology or non-display technology.

Any circuit substrate that uses a conductive structure containing the first conductive wiring D1, the second conductive wiring D2, and the converging wiring D for auxiliary voltage input involves the technology of this disclosure. A display using such a circuit substrate, or an electronic device using such a display all involve the technology of this disclosure.

As long as the features of the various embodiments do not violate or conflict the spirit of the disclosure, they can be combined arbitrarily.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A circuit substrate (100), in particular for use in an electronic device, particularly an image display device, comprising:
a substrate (102), including an active area (104) and a peripheral area surrounding the active area;
a signal transmitting structure, disposed on the active area (104) and the peripheral area; and
a conductive structure, disposed on the peripheral area, electrically connected to the signal transmitting structure, and including first conductive wiring (D1), second conductive wiring (D2), and converging wiring (D),
wherein:
the converging wiring (D) is electrically connected to the first conductive wiring (D1) and the second conductive wiring (D2), and the converging wiring has a first end (E1) and a second end (E2);
a first signal (S1) from the first conductive wiring (d1) and a second signal (S2) from the second conductive wiring (D2) are transferred to the converging wiring (D) through the first end (E1) of the converging wiring; and
the converging wiring (D) outputs a third signal (S3) to the signal transmitting structure (106) through the second end (E2).

2. The circuit substrate as claimed in claim 1, wherein:
the signal transmitting structure includes a conductive ring (106) disposed on the peripheral area and adjacent to at least three sides of the active area (104); and
the signal transmitting structure receives the third signal (S3) at the second end (E2) of the converging wiring (D).

3. The circuit substrate as claimed in claim 2, wherein: the signal transmitting structure further includes a transparent conductive layer (110) disposed on the active area (104) and a part of the peripheral area, and is electrically connected to the conductive ring (106).

4. The circuit substrate as claimed in any of the preceding claims, wherein: the third signal (S3) is a common voltage.

5. The circuit substrate as claimed in any of the preceding claims, wherein:
the converging wiring (D) is divided into a first portion and a second portion;
a width of the first portion is not narrower than 30% of a maximum width (Wmax) of the converging wiring (D);
a width of the second portion is narrower than 30% of the maximum width (Wmax);
the first portion and the second portion have an overall length (LD); and
a ratio of a length (L1) of the first portion to the overall length (LD) is greater than or equal to 50%.

6. The circuit substrate as claimed in claim 5, wherein:
the ratio is greater than or equal to 70%.

7. The circuit substrate as claimed in claim 5 or 6, further comprising:
an electrostatic protection component (302), electrically connected to the converging wiring (D).

8. The circuit substrate as claimed in any of the preceding claims, wherein:
the conductive structure (106) further includes a bridge structure (B) electrically connecting the first end (E1) of the converging wiring (D) with the first conductive wiring (D1), and electrically connecting the first end (E1) of the converging wiring (D) with the second conductive wiring (D2).

9. The circuit substrate as claimed in claim 8, wherein:
the bridge structure (B) is built in a first layer of the circuit substrate (100);
the first conductive wiring (D1), the second conductive wiring (D2), and the converging wiring (D) are built in a second layer of the circuit substrate (100); and
the first layer and the second layer is each at a different distance away from the substrate (102).

10. The circuit substrate as claimed in any of the preceding claims, further comprising:
a plurality of pads (bp1-bp9), disposed on the peripheral area;
wherein the first conductive wiring (D1) is electrically connected to at least two pads.

11. The circuit substrate as claimed in any of the preceding claims, further comprising:
an active component (602), disposed on the active area (104); and
a pixel electrode (604), electrically connected to the active component (602);
wherein the pixel electrode and the signal transmitting structure overlap each other.

12. An electronic device, comprising:
a circuit substrate (100) as claimed in any of claims 1 to 11;
a first circuit board (114), bonded to the circuit substrate (100), and operative to provide the first conductive wiring (D1) with the first signal (S1); and
a second circuit board (116), connected with the circuit substrate (100), and operative to provide the second conductive wiring (D2) with the second signal (S2).

13. The electronic device as claimed in claim 12, further comprising:
a color filter (608); and
a liquid-crystal layer (610), disposed between the circuit substrate (100) and the color filter (608).

14. The electronic device as claimed in claim 12 or 13, which is a display device.

15. The electronic device as claimed in claim 12, wherein:
the signal transmitting structure includes a conductive ring disposed on the peripheral area and adjacent to at least three sides of the active area;
the signal transmitting structure receives the third signal at the second end of the converging wiring; and
the signal transmitting structure further includes a transparent conductive layer disposed on the active area and a part of the peripheral area, and is electrically connected to the conductive ring.
